# EUROPÄISCHE PATENTSCHRIFT

(11) **EP 1 310 043 B1**
(45) Veröffentlichungstag und Bekanntmachung des Hinweises auf die Patenterteilung: **04.01.2006**
(21) Anmeldenummer: 01967005.8
(22) Anmeldetag: 15.08.2001
(51) Int. Cl.: H03F 3/45

(54) **DIFFERENTIELLER, KOMPLEMENTÄRER VERSTÄRKER**
DIFFERENTIAL COMPLEMENTARY AMPLIFIER
AMPLIFICATEUR DIFFERENTIEL COMPLEMENTAIRE

(30) Priorität: 15.08.2000 DE 10042170
(43) Veröffentlichungstag der Anmeldung: 14.05.2003
(73) Patentinhaber: Infineon Technologies AG, 81669 München (DE)
(72) Erfinder: SCHROEDINGER, Karl, 14089 Berlin (DE); STIMMA, Jaro, 13587 Berlin (DE)
(74) Vertreter: Müller, Wolfram Hubertus
(86) Internationale Anmeldenummer: PCT/DE2001/003094
(87) Internationale Veröffentlichungsnummer: WO 2002/015394

(56) Entgegenhaltungen:
- EP-A- 0 355 906
- FR-A- 2 667 744
- US-A- 3 991 380
- US-A- 5 206 602
- W. CORDARO: "COMPLEMENTARY FET DIFFERENTIAL AMPLIFIER" IBM TECHNICAL DISCLOSURE BULLETIN., Bd. 16, Nr. 10, März 1974 (1974-03), Seiten 3227-3228, XP002185177 IBM CORP. NEW YORK., US ISSN: 0018-8689

## Beschreibung

Die Erfindung betrifft einen differentiellen, komplementären Verstärker nach dem Oberbegriff des Anspruchs 1. Derartige Verstärker dienen der Verstärkung differentieller analoger oder digitaler Eingangssignale. Sie weisen einen breiten Anwendungsbereich auf und eignen sich insbesondere zur Verstärkung hochfrequenter Signale mit Datenraten bis in den Gbit/s-Bereich.

Aus der Druckschrift US-A-4937476 ist ein differentieller Verstärker mit zwei parallel angeordneten Verstärkerzweigen bekannt, die jeweils ein Paar CMOS Transistoren aufweisen. Ein drittes Paar CMOS Transistoren steuert die Stromzufuhr für die beiden Verstärkerzweige und stellt deren Arbeitspunkt ein. Der Ausgang der miteinander verbundenen Drain-Anschlüsse des ersten Verstärkerzweigs liegt dazu an den Gate-Anschlüssen des dritten CMOS-Transistorpaars. Der bekannte Verstärker stellt zu einer an den Gate-Anschlüssen der beiden Verstärkerzweige anliegenden Differenzspannung am Ausgang des zweiten Verstärkerzweigs eine Ausgangsspannung zur Verfügung.

Die Druckschrift US-A-4958133 beschreibt einen differentiellen, komplementären Verstärker mit parallel angeordneten CMOS-Verstärkerzweigen. Es wird eine verbesserte Gegenkopplung beschrieben, die ein hohes Maß an Gleichtaktunterdrückung und eine hohe Spannungsverstärkung für differentielle Signale bereitstellt.

Bei den aus den beiden genannten Druckschriften bekannten differentiellen Verstärkern dient stets ein Zweig des Verstärkers allein der Arbeitspunktstabilisierung und der andere Zweig des Verstärkers als eigentlicher Verstärker. Dadurch wird die Verstärkung bei relativ großer Stromaufnahme begrenzt. Die obengenannten Verstärkerschaltungen weisen außerdem jeweils nur einen "single ended" - Ausgang auf. Dies verhindert eine einfache Serienschaltung mit einer zweiten Differenzverstärkerstufe.

Ein weiterer differentieller, komplementärer Verstärker mit zwei Verstärkerzweigen ist in der US-A-6028467 beschrieben.

Aus W. CORDARO: "Complementary FET Differential Amplifier", IBM Technical Disclosure Bulletin, Bd. 16, Nr. 10, März 1974 (1974-03), Seiten 3227-3228 ist ein gattungsgemäßer differentieller, komplementärer Verstärker bekannt. Dieser weist zwei MOSFET Verstärkerzweige auf. Der zweite Verstärkerzweig wird gegenüber dem ersten Verstärkerzweig gegensinnig betrieben. Die Ausgänge der beiden Verstärkerzweige bilden einen differentiellen Ausgang und sind jeweils über einen Lastwiderstand in einem Knotenpunkt miteinander verbunden.

Der Erfindung liegt die Aufgabe zu Grunde, den gattungsgemäßen differentiellen, komplementären Verstärker weiterzuentwickeln, wobei eine möglichst stabile Schaltung bereitgestellt werden soll.

Diese Aufgabe wird erfindungsgemäß durch einen differentiellen Verstärker mit den Merkmalen des Anspruchs 1 gelöst. Bevorzugte und vorteilhafte Ausgestaltungen der Erfindung sind in den Unteransprüchen angegeben.

Bei einem differentiellen Verstärker mit zwei Verstärkerzweigen wird der zweite Verstärkerzweig gegenüber dem ersten Verstärkerzweig gegensinnig betrieben, bilden die Ausgänge der beiden Verstärkerzweige einen differentiellen Ausgang und sind diese jeweils über einen Lastwiderstand in einem Knotenpunkt miteinander verbunden. Über die an diesem Knotenpunkt anliegende Spannung wird der Arbeitspunkt der beiden Verstärkerzweige eingestellt. Dabei ist die differentielle Last in zwei Einzelwiderstände aufgeteilt und dient die zwischen den Einzelwiderständen anliegende Spannung zur Einstellung des Arbeitspunktes der Verstärkerzweige. Durch die Variation der Widerstandswerte der Lastwiderstände können die Bandbreite und die Verstärkung beeinflußt werden.

Erfindungsgemäß weisen der erste und der zweiten Verstärkerzweig zusätzliche Gegenkopplungsmittel auf, die die Schaltung stabilisieren. Die Gegenkopplungsmittel weisen bevorzugt Widerstände auf, die jeweils an die Source-Anschlüsse des ersten und zweiten Verstärkerzweigs angeschlossen sind. Über die Widerstände kann die Bandbreite des Verstärkers (auf Kosten der Verstärkung) verbreitert werden, d.h. ein Verstärkungsabfall setzt erst bei höheren Frequenzen ein.

Aufgrund des Umstandes, daß die Verstärkerzweige gegeneinander arbeiten, werden an den jeweiligen Verstärkerzweigen anliegende Spannungsdifferenzen mit doppelter Amplitude verstärkt. Dementsprechend liegt eine hohe Verstärkung vor. Die Einstellung des Arbeitspunktes der beiden Verstärkerzweige über die an dem Knotenpunkt zwischen den beiden Lastwiderständen der Verstärkerzweige anliegende Spannung ermöglicht eine genaue Einstellung des Arbeitspunktes, da die Spannung an dem Knotenpunkt fast keine Wechselanteile aufweist. Aufgrund der symmetrischen Schaltungsdimensionierung stellt sich dabei eine Spannung in Höhe der halben Betriebsspannung (Vdd/2) ein. Des weiteren ist die Arbeitspunkteinstellung aufgrund der erfolgenden Rückkopplung "self-biased".

Der Verstärker verfügt über einen differentiellen Ausgang, d.h. die Differenz der Spannungen an den Ausgangsknoten des Verstärkers kann weiteren Verstärkerstufen zur Verfügung gestellt werden. Dies ermöglicht eine einfache Zusammenschaltung von mehreren Verstärkerstufen.

Bei dem erfindungsgemäßen Verstärker dienen beide Verstärkerzweige als Verstärker und wird aus beiden Zweigen ein Signal zur Arbeitspunktstabilisierung abgeleitet, so daß eine voll differentielle, hochsymmetrische Verstärkerschaltung vorliegt. Damit wird bei kleinerer Stromaufnahme eine wesentlich höhere Verstärkung als bei bekannten differentiellen Verstärkern erzielt. Zusätzlich kann eine sehr kleine Versorgungsspannung von kleiner als 2 Volt vorgesehen werden, wie sie bei modernen CMOS Technologien mit Strukturbreiten kleiner als 0,2 Mikrometer erforderlich ist.

In einer bevorzugten Ausgestaltung der Erfindung werden die Verstärkerzweige um die hälftige Betriebsspannung bzw. Versorgungsspannung ausgesteuert, d.h. wird der Arbeitspunkt der Transistoren der Verstärkerzweige auf die halbe Betriebsspannung gelegt. In diesem Ansteuerungsbereich ist die Steilheit der Übertragungskennlinie eines komplementären MOSFET maximal und wird eine dementsprechend hohe Verstärkung zur Verfügung gestellt. Als weiterer Vorteil ergibt sich, daß mehrere Differenzverstärker in einfacher Weise in Reihe geschaltet werden können.

Jedoch liegt auch ein asymmetrisches Design im Rahmen der Erfindung, bei dem die Aussteuerung um eine von der halben Betriebsspannung verschobene Spannung erfolgt. Die Transistoren sind dann entsprechend zu dimensionieren.

Bevorzugt erfolgt die Einstellung des Arbeitspunkts der beiden Verstärkerzweige durch Einstellen der Gatespannung von mindestens zwei FET-Steuertransistoren, die die Stromzufuhr für die beiden Verstärkerzweige steuern, wobei der Gate-Anschluß der FET-Steuertransistoren jeweils mit dem Knotenpunkt zwischen den beiden Lastwiderständen gekoppelt ist. Insbesondere handelt es sich bei den FET-Steuertransistoren um ein CMOS-Paar mit einem p-Kanal Steuertransistor und einem n-Kanal Steuertransistor.

Die Spannung am Knotenpunkt zwischen den Lastwiderständen steuert als Gatespannung die Stromzufuhr für die CMOS Steuertransistoren. Über die Stromzufuhr wird der Arbeitspunkt für den ersten und zweiten Verstärkerzweig eingestellt. Dabei wirken die Steuertransistoren für die Verstärkerzweige als arbeitspunktstabilisierende Widerstände.

In einer bevorzugten Ausbildung der Erfindung sind der Source-Anschluß des p-Kanal Steuertransistors mit der Betriebsspannung und der Source-Anschluß des n-Kanal Steuertransistors mit Masse verbunden und ist der erste und der zweite Verstärkerzweig zwischen den Drain-Anschlüssen der beiden Steuertransistoren angeordnet. Hierzu ist der Drain-Anschluß des p-Kanal Steuertransistors mit dem Source-Anschluß des p-Kanal Transistors des ersten Verstärkerzweigs und dem Source-Anschluß des p-Kanal Transistors des zweiten Verstärkerzweigs verbunden. Weiter ist der Drain-Anschluß des n-Kanal Steuertransistors mit dem Source-Anschluß des n-Kanal Transistors des ersten Verstärkerzweigs und dem Source-Anschluß des n-Kanal Transistors des zweiten Verstärkerzweigs verbunden. Die jeweiligen p-Kanal und n-Kanal Transistoren weisen übereinstimmende Betriebsdaten auf, so daß eine vollsymmetrische Schaltung vorliegt.

Bevorzugt werden die FET-Steuertransistoren im Triodenbereich betrieben. Sie wirken dabei als Widerstände, die ein lineares Verhalten aufweisen. Damit kann die über die Betriebsspannung die Stromeinspeisung in die Verstärkerzweige eingestellt werden.

In einer vorteilhaften Weiterbildung der Erfindung ist der Knotenpunkt zwischen den beiden Lastwiderständen der gegeneinander arbeitenden Verstärkerzweige mit einem Kondensator gekoppelt. Dies weist den Vorteil auf, daß etwaige Unsymmetrien am Knotenpunkt, die Einfluß auf die Steuertransistoren haben könnten, herausgefiltert werden.

In einer weiteren Weiterbildung der Erfindung ist der Knotenpunkt zwischen den beiden Lastwiderständen jeweils über einen Tiefpassfilter mit den Gate-Anschlüssen der Steuertransistoren verbunden. Dadurch werden ebenfalls etwaige Unsymmetrien am Knotenpunkt herausgefiltert, so daß an den Steuertransistoren keine Wechselsignale anliegen.

In einer bevorzugten Ausgestaltung des Verstärkers ist den Steuertransistoren jeweils eine Stromspiegelschaltung mit einem MOSFET-Transistor zugeordnet, dessen Eingang ebenfalls mit dem Knotenpunkt zwischen den beiden Lastwiderständen verbunden ist. Dadurch können die Steuertransistoren in der Sättigung betrieben werden. Als Folge werden die Verstärkerzweige hochohmiger und die Verstärkung nimmt zu.

Mit Vorteil erfolgt eine Anordnung der Widerstände der Gegenkopplungsmittel derart, daß die Steuertransistoren jeweils in zwei Transistoren gleicher Größe geteilt sind, deren Gate-Anschlüsse mit dem Knotenpunkt zwischen den Lastwiderständen, deren Source-Anschlüsse mit der Betriebsspannung bzw. mit Masse und deren Drain-Anschlüsse mit einem der beiden Verstärkerzweige verbunden sind, wobei zwei parallele Zweige von Verstärkerzweigen und Steuertransistoren entstehen, und wobei die beiden Zweige zwischen Verstärkerzweig und Steuertransistor jeweils durch mindestens einen Widerstand miteinander verbunden sind.

Dabei wird mit Vorteil parallel zu den Widerständen jeweils ein Kondensator geschaltet. Die dabei entstehenden RC-Glieder beschleunigen durch zusätzliche Anhebung der hochfrequenten Signalanteile die Anstiegsflanken eines zu verstärkenden Digitalsignals (sogenanntes "Peaking").

Die Erfindung wird nachfolgend unter Bezugnahme auf die Figuren der Zeichnung näher erläutert. Es zeigen:
- Fig. 1: die Schaltungsanordnung eines differentiellen Verstärkers,
- Fig. 2: eine erfindungsgemäße Weiterbildung des Verstärkers der Fig. 1,
- Fig. 3: eine zweite Weiterbildung des Verstärkers der Fig. 1, und
- Fig. 4: eine dritte Weiterbildung des Verstärkers der Fig. 1.

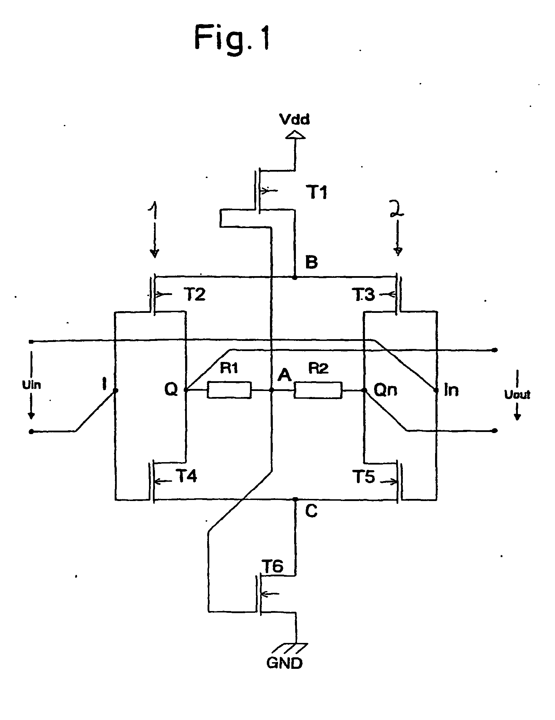

Es wird darauf hingewiesen, dass die Schaltungsanordnungen der Figuren 1, 3 und 4 für sich genommen nicht die vorliegende Erfindung betreffen, jedoch dem besseren Verständnis des Hintergrunds und von Unteraspekten der Erfindung dienen.

Figur 1 zeigt die Grundschaltung eines differentiellen Verstärkers. Sie weist drei CMOS p-Kanal Transistoren T1, T2, T3, drei CMOS n-Kanal Transistoren T4, T5, T6 und zwei Lastwiderstände R1, R2 auf. Die Transistoren T2 und T3 sowie T4 und T5 sind jeweils von der gleichen Größe und bilden zwei CMOS-Inverter 1, 2 mit komplementären, in Reihe geschalteten Transistoren T2, T4 und T3, T5 aus.

Die beiden CMOS-Inverter 1, 2 stellen zwei gegeneinander arbeitetende, differentielle Verstärkerzweige dar, die zwischen zwei Drainknoten B, C der CMOS Transistoren T1, T6 angeordnet sind. Die CMOS Transistoren T1, T6 stellen Steuertransistoren zur Steuerung des Stromflusses durch die Verstärkerstufen 1, 2 und zur Einstellung des Arbeitspunktes der Transistoren T2, T4, T3, T5 dar. Dabei sind die Source-Anschlüsse der p-Kanal Transistoren T2, T3 mit dem Drain-Anschluß des p-Kanal Transistors T1 sowie die Source-Anschlüsse der n-Kanal Transistoren mit dem Drain-Anschluß des n-Kanal Transistors T6 verbunden. Der Source-Anschluß der Transistors T1 ist mit der Betriebsspannung Vdd und der Source-Anschluß des Transistors T6 mit Masse verbunden.

An dem gemeinsamen, fest verkoppeleten Drain-Anschluß Q der Transistoren T2, T4 ist der Lastwiderstand R1 und an dem gemeinsamen, fest verkoppeleten Drain-Anschluß Qn der Transistoren T3, T5 der Lastwiderstand R2 angeordnet. Die Lastwiderstände R1, R2 bilden die differentielle Last und können entsprechend der benötigten Bandbreite dimensioniert werden.

Die Ausgänge Q, Qn der beiden Verstärkerzweige 1, 2 sind über die Lastwiderstände R1, R2 in einem Knotenpunkt A fest miteinander verbunden. Der Knotenpunkt A ist wiederum mit den Gate-Anschlüssen der beiden CMOS Transistoren T1, T6 verbunden und steuert damit die Stromzufuhr für die Transistoren T1, T6. Dadurch wird eine Arbeitspunktstabilisierung für die Transistoren T2, T4, T3, T5 erzielt (self-biasing).

Eine differentielle Eingangsspannung Uin wird über die Eingangsknoten I, In an die Gate-Anschlüsse der Transistoren T2, T4 und T3, T5 der beiden Verstärkerzweige 1, 2 angelegt. Eine Ausgangsspannung Uout wird an den Knotenpunkten Q, Qn der Drain-Anschlüsse der beiden Verstärkerzweige abgenommen. Dabei steht der Index "n" (n=negiert) für die jeweils invertierten Knoten bzw. Signale.

Beide Verstärkerzweige 1, 2 arbeiten dabei gegeneinander, so daß eine Änderung der Eingangsspannung beispielsweise sowohl zu einer Spannungserhöhung am Bezugspunkt Q als auch zu einer Spannungserniederigung am Bezugspunkt Qn führt. Es findet somit eine hohe Verstärkung mit "doppelter Amplitude" statt.

Der Arbeitspunkt der Transistoren T2, T4 und T3, T5 wird mittels der am Mittelabgriff A zwischen den Lastwiderständen anliegenden Spannung über das CMOS Transistorpaar T1, T6 eingestellt, das den Drain-Strom durch die Transistoren T2, T4 sowie T3, T5 steuert. In dem Ausführungsbeispiel der Figur 1 werden die CMOS Transistoren T1, T6 dabei im Triodenbereich betrieben, so daß sie einen Widerstand in der Source-Leitung der Transistoren T2, T4 sowie T3, T5 darstellen.

Am Verbindungsknoten A zwischen den beiden Lastwiderständen R1, R2 liegt eine Spannung an, die fast keinen Wechselanteil aufweist. Dies ergibt sich aus der Symmetrie der Schaltung. Dabei wird aus beiden Verstärkerzweigen 1, 2 ein Signal zur Arbeitspunktstablisierung abgeleitet.

Die Verstärkerschaltung wird um die Mittenspannung Vdd/2 ausgesteuert, so daß die Inverter 1, 2 im optimalen Arbeitspunkt angesteuert werden und eine hohe, lineare Verstärkung aufweisen. So liegt die maximale Verstärkung eines CMOS Inverters gerade bei einer Ansteuerung mit der halben Betriebsspannung vor. Die Widerstände R1 und R2 werden bevorzugt identisch gewählt, so daß eine vollständig symmetrische Schaltung vorliegt.

Die Ansteuerung um die Mittenspannung Vdd/2 weist auch den Vorteil auf, daß mehrere Verstärkerstufen in einfacher Weise in Reihe geschaltet werden können.

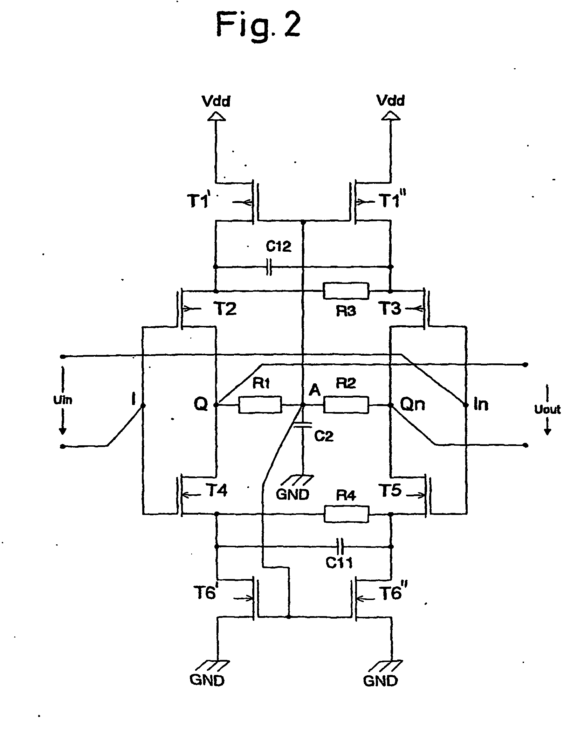

In Figur 2 ist eine erfindungsgemäße Weiterbildung der Schaltung gemäß Figur 1 dargestellt, die zusätzlich eine Gegenkopplung in Form von Widerständen R3, R4 aufweist, denen jeweils ein Kondensator C11, C12 parallel geschaltet ist. Die Transistoren T1 und T2 der Fig. 1 sind dabei jeweils in Transistoren T1', T1'' und T6', T6" der halben Größe geteilt, deren Gate-Anschlüsse mit dem Knotenpunkt A, deren Source-Anschlüsse mit der Betriebsspannung Vdd bzw. mit Masse und deren Drain-Anschlüsse jeweils mit einem Verstärkerzweig 1, 2 verbunden sind. Dabei bilden sich parallele Zweige des Verstärkers aus, zwischen die die Widerstände R3, R4 und die Kondensatoren C11, C12 geschaltet sind. So ist beispielsweise der Widerstand R3 mit den beiden Source-Anschlüssen der Transistoren T2, T3 verbunden.

Durch die Gegenkopplung über die Widerstände R3, R4 wird die Bandbreite des Verstärkers erhöht, allerdings auf Kosten der Verstärkung. Die Kondensatoren C11, C12 bilden zusammen mit den Widerständen R3, R4 RC-Glieder und beschleunigen über zusätzliche Anhebung der hochfrequenten Signalanteile die Flanken zu verstärkender Digitalsignale (sogenanntes "Peaking"). Dies führt dazu, daß ein sinusförmiges Eingangssignal tendenziell eine Rechteckform erhält. Dieser Effekt zeigt sich insbesondere bei mehreren in Reihe geschalteten Verstärkerstufen.

Zusätzlich ist in Figur 2 ein Kondensator 2 vorgesehen, der mit dem Bezugspunkt A und Masse verbunden ist und etwaige Unsymmetrien im Differenzverstärker herausfiltert, so daß am den Steuertransistoren T1', T1'', T6', T6" keine Wechselsignale anliegen.

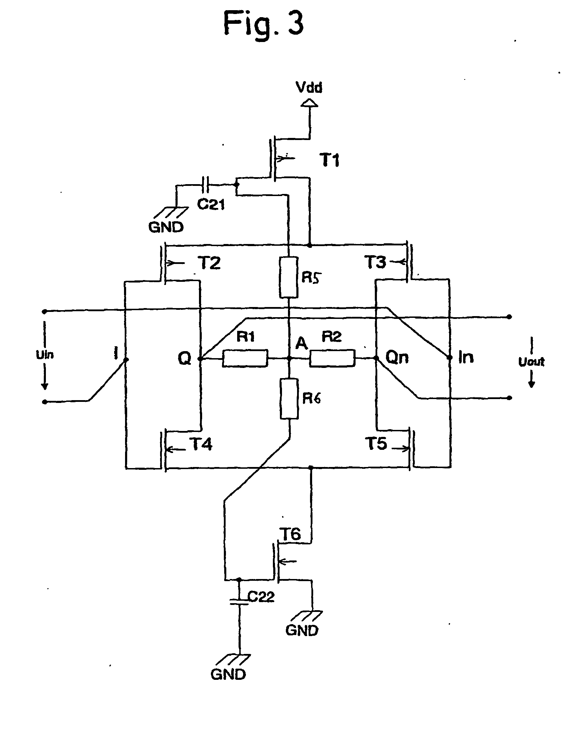

In der Schaltung der Figur 3 ist zwischen dem Knotenpunkt A und den Gate-Anschlüssen der Steuertransistoren T1, T6 jeweils ein Tiefpass bestehend aus Widerständen R5, R6 und Kondensatoren C21, C22 angeordnet. Die Lastwiderstände R1, R2 und die dazu in Reihe geschalteten Widerstände R5, R6 können dabei unabhängig dimensioniert werden. Bevorzugt sind R1 gleich R2 und R5 gleich R6, um die Symmetrie der Schaltung aufrecht zu halten. Ebenso weisen die Kondensatoren C21, C22 die gleiche Kapazität auf.

Die Tiefpässe dienen ebenfalls einer Filterung etwaiger Unsymmetrien am Differenzverstärker bzw. am Knotenpunkt A um sicherzustellen, daß an den Gate-Anschlüssen der Steuertransistoren T1, T6 keine AC-Anteile anliegen.

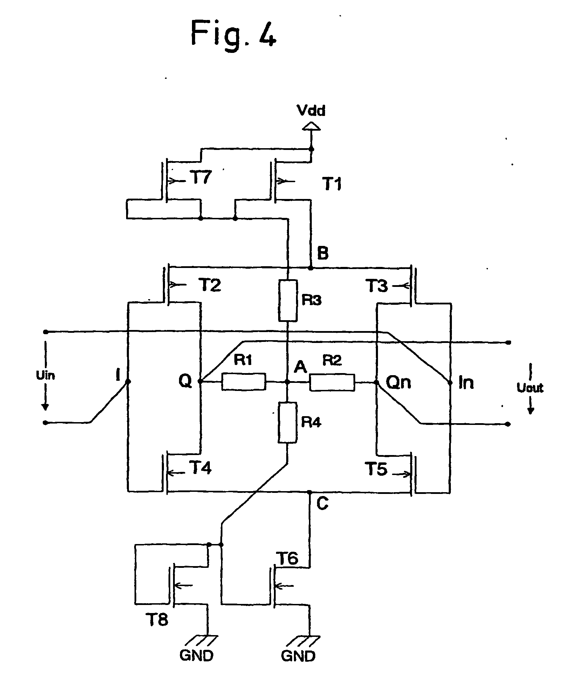

In Figur 4 ist die Schaltung der Fig. 1 dahingehend weitergebildet, daß die Rückkopplung über den Knotenpunkt A über Stromspiegel erfolgt. Dazu ist den Steuertransistoren T1, T6 jeweils eine Stromspiegelschaltung mit einem MOSFET-Transistor T7, T8 zugeordnet ist. Der eine Transistor T7 ist dabei ein p-Kanal MOSFET, dessen Eingang mit dem Knotenpunkt A und dessen Ausgang mit dem Source-Anschluß des Steuertransistors T1 bzw. mit der Bezugsspannung verbunden ist. Entsprechend ist der andere Transistor T8 ein n-Kanal MOSFET, dessen Eingang mit dem Knotenpunkt A und dessen Ausgang mit dem Source-Anschluß des Steuertransistors T6 bzw. mit Masse verbunden ist.

Die Transistoren T7, T8 werden in Sättigung betrieben, wobei durch den Knotenpunkt A der Strom durch die Transistoren T7, T8 eingestellt wird. Dieser wird an die Steuertransistoren T1, T6 gespiegelt, was dazu führt, daß auch die Steuertransistoren T1, T6 in Sättigung, d.h. im Abschnürbereich betrieben werden.

Bei der Schaltung der Fig. 4 wird der Drainknoten B, C durch Betreiben der Steuertransistoren T1, T6 in der Sättigung hochohmiger, so daß die Verstärkung steigt.

## Patentansprüche

1. Differentieller, komplementärer Verstärker, insbesondere zur Verstärkung hochfrequenter Signale, mit einem ersten komplementären MOSFET Verstärkerzweig (1), der einen p-Kanal Transistor und einen dazu in Reihe geschalteten n-Kanal Transistor aufweist, und einem zweiten komplementären MOSFET Verstärkerzweig (2), der ebenfalls einen p-Kanal Transistor und einen dazu in Reihe geschalteten n-Kanal aufweist, wobei
- der zweite Verstärkerzweig (2) gegenüber dem ersten Verstärkerzweig (1) gegensinnig betrieben wird,
- die Ausgänge der beiden Verstärkerzweige (1, 2) einen differentiellen Ausgang bilden und jeweils über einen Lastwiderstand (R1, R2) in einem Knotenpunkt (A) miteinander verbunden sind, und
- über die an diesem Knotenpunkt (A) anliegende Spannung der Arbeitspunkt der beiden Verstärkerzweige (1, 2) eingestellt wird,
**dadurch gekennzeichnet,**
**dass** Gegenkopplungsmittel (R3, R4; C11, C12) für den ersten und den zweiten Verstärkerzweig vorgesehen sind.

2. Verstärker nach Anspruch 1, **dadurch gekennzeichnet, daß** die Verstärkerzweige (1, 2) um die hälftige Betriebsspannung (Vdd/2) ausgesteuert sind.

3. Verstärker nach Anspruch 1 oder 2, **dadurch gekennzeichnet, daß** die Bandbreite des Verstärkers durch Variation der Lastwiderstände (R1, R2) veränderbar ist.

4. Verstärker nach mindestens einem der Ansprüche 1 bis 3, **dadurch gekennzeichnet, daß** der Arbeitspunkt der beiden Verstärkerzweige (1, 2) durch Einstellung der Gatespannung von mindestens zwei FET-Steuertransistoren (T1, T6) eingestellt wird, die die Stromzufuhr für die beiden Verstärkerzweige (1, 2) steuern, wobei der Gate-Anschluß der FET-Steuertransistoren (T1, T6) jeweils mit dem Knotenpunkt (A) gekoppelt ist.

5. Verstärker nach Anspruch 4, **dadurch gekennzeichnet, daß** die FET-Steuertransistoren einen p-Kanal Steuertransistor (T1) und einen dazu in Reihe geschalteten n-Kanal Steuertransistor (T6) eines komplementären MOSFET-Transistorpaars ausbilden, das die Stromzufuhr für den ersten und zweiten Verstärkerzweig (1, 2) steuert.

6. Verstärker nach Anspruch 5, **dadurch gekennzeichnet, daß** der Source-Anschluß des p-Kanal Steuertransistors (T1) mit der Betriebsspannung und der Source-Anschluß des n-Kanal Steuertransistors (T6) mit Masse verbunden ist und der erste und der zweite Verstärkerzweig (1, 2) zwischen den Drain-Anschlüssen der beiden Steuertransistoren (T1, T6) angeordnet ist.

7. Verstärker nach Anspruch 6, **dadurch gekennzeichnet, daß** der Drain-Anschluß des p-Kanal Steuertransistors (T1) mit dem Source-Anschluß des p-Kanal Transistors (T2) des ersten Verstärkerzweigs (1) und dem Source-Anschluß des p-Kanal Transistors (T3) des zweiten Verstärkerzweigs (2) und der Drain-Anschluß des n-Kanal Steuertransistors (T6) mit dem Source-Anschluß des n-Kanal Transistors (T4) des ersten Verstärkerzweigs (1) und dem Source-Anschluß des n-Kanal Transistors (T5) des zweiten Verstärkerzweigs (2) verbunden ist.

8. Verstärker nach mindestens einem der Ansprüche 4 bis 7, **dadurch gekennzeichnet, daß** die FET-Steuertransistoren (T1, T6) im Triodenbereich betrieben werden.

9. Verstärker nach mindestens einem der Ansprüche 1 bis 8, **dadurch gekennzeichnet, daß** der erste und der zweite Verstärkerzweig (1, 2) jeweils durch CMOS p-Kanal und n-Kanal Transistoren (T2, T4; T3, T5) gebildet werden, von denen jeweils zwei gleich ausgebildet sind.

10. Verstärker nach mindestens einem der vorangehenden Ansprüche, **dadurch gekennzeichnet, daß** der Knotenpunkt (A) mit einem Kondensator (C2) gekoppelt ist.

11. Verstärker nach mindestens einem der vorangehenden Ansprüche, **dadurch gekennzeichnet, daß** der Knotenpunkt (A) jeweils über einen Tiefpassfilter (R5, C21; R6, C22) mit den Gate-Anschlüssen der Steuertransistoren (T1, T6) verbunden ist.

12. Verstärker nach mindestens einem der vorangehenden Ansprüche, **dadurch gekennzeichnet, daß** den Steuertransistoren (T1, T6) jeweils eine Stromspiegelschaltung mit einem MOSFET-Transistor (T7, T8) zugeordnet ist, dessen Eingang mit dem Knotenpunkt (A) und dessen Ausgang mit dem Source-Anschluß des jeweiligen Steuertransistores (T1, T6) verbunden ist.

13. Verstärker nach Anspruch 12, **dadurch gekennzeichnet, daß** die Steuertransistoren (T1, T6) im Abschnürbereich betrieben werden.

14. Verstärker nach mindestens einem der vorangehenden Ansprüche, **dadurch gekennzeichnet, daß** die Gegenkopplungsmittel Widerstände (R3, R4) aufweisen, die jeweils an die Source-Anschlüsse des ersten und zweiten Verstärkerzweigs (1, 2) angeschlossen sind.

15. Verstärker nach Anspruch 14, **dadurch gekennzeichnet, daß** die Steuertransistoren jeweils in zwei Transistoren (T1', T1'';T6', T6'') gleicher Größe geteilt sind, deren Gate-Anschlüsse mit dem Knotenpunkt (A), deren Source-Anschlüsse mit der Betriebsspannung bzw. Masse und deren Drain-Anschlüsse mit einem der beiden Verstärkerzweige (1, 2) verbunden sind, wobei zwei parallele Zweige von Verstärkerzweigen und Steuertransistoren entstehen, und wobei die beiden Zweige zwischen Verstärkerzweig und Steuertransistor jeweils durch mindestens einen Widerstand (R3, R4) miteinander verbunden sind.

16. Verstärker nach Anspruch 15, **dadurch gekennzeichnet, daß** parallel zu den Widerständen (R3, R4) jeweils ein Kondensator (C12, C11) geschaltet ist.

## Claims

1. Differential, complementary amplifier, in particular for amplifying high-frequency signals, having a first complementary MOSFET amplifier path (1), which has a p-channel transistor and an n-channel transistor connected in series therewith, and a second complementary MOSFET amplifier path (2), which likewise has a p-channel transistor and an n-channel transistor connected in series therewith,
- the second amplifier path (2) being operated in the opposite direction relative to the first amplifier path (1),
- the outputs of the two amplifier paths (1, 2) forming a differential output and being in each case connected to one another via a load resistor (R1, R2) at a node (A), and
- the operating point of the two amplifier paths (1, 2) being set by way of the voltage present at said node (A),
**characterized in that** negative feedback means (R3, R4; C11, C12) are provided for the first and second amplifier paths.

2. Amplifier according to Claim 1, **characterized in that** the amplifier paths (1, 2) are driven by half the operating voltage (Vdd/2).

3. Amplifier according to Claim 1 or 2, **characterized in that** the bandwidth of the amplifier is variable by varying the load resistors (R1, R2).

4. Amplifier according to at least one of Claims 1 to 3, **characterized in that** the operating point of the two amplifier paths (1, 2) is set by setting the gate voltage of at least two FET control transistors (T1, T6), which control the current supply for the two amplifier paths (1, 2), the gate terminal of the FET control transistors (T1, T6) in each case being coupled to the node (A).

5. Amplifier according to Claim 4, **characterized in that** the FET control transistors form a p-channel control transistor (T1) and an n-channel control transistor (T6) - connected in series therewith - of a complementary MOSFET transistor pair which controls the current supply for the first and second amplifier paths (1, 2).

6. Amplifier according to Claim 5, **characterized in that** the source terminal of the p-channel control transistor (T1) is connected to the operating voltage and the source terminal of the n-channel control transistor (T6) is connected to earth and the first and second amplifier paths (1, 2) are arranged between the drain terminals of the two control transistors (T1, T6).

7. Amplifier according to Claim 6, **characterized in that** the drain terminal of the p-channel control transistor (T1) is connected to the source terminal of the p-channel transistor (T2) of the first amplifier path (1) and to the source terminal of the p-channel transistor (T3) of the second amplifier path (2), and the drain terminal of the n-channel control transistor (T6) is connected to the source terminal of the n-channel transistor (T4) of the first amplifier path (1) and to the source terminal of the n-channel transistor (T5) of the second amplifier path (2).

8. Amplifier according to at least one of Claims 4 to 7, **characterized in that** the FET control transistors (T1, T6) are operated in the triode region.

9. Amplifier according to at least one of Claims 1 to 8, **characterized in that** the first and second amplifier paths (1, 2) are in each case formed by CMOS p-channel and n-channel transistors (T2, T4; T3, T5), two of which in each case are formed identically.

10. Amplifier according to at least one of the preceding claims, **characterized in that** the node (A) is coupled to a capacitor (C2).

11. Amplifier according to at least one of the preceding claims, **characterized in that** the node (A) is in each case connected via a low-pass filter (R5, C21; R6, C22) to the gate terminals of the control transistors (T1, T6).

12. Amplifier according to at least one of the preceding claims, **characterized in that** the control transistors (T1, T6) are in each case assigned a current mirror circuit with a MOSFET transistor (T7, T8), whose input is connected to the node (A) and whose output is connected to the source terminal of the respective control transistor (T1, T6).

13. Amplifier according to Claim 12, **characterized in that** the control transistors (T1, T6) are operated in the pinch-off region.

14. Amplifier according to at least one of the preceding claims, **characterized in that** the negative feedback means have resistors (R3, R4), which are in each case connected to the source terminals of the first and second amplifier paths (1, 2).

15. Amplifier according to Claim 14, **characterized in that** the control transistors are in each case divided into two transistors (T1', T1''; T6', T6'') of identical size whose gate terminals are connected to the node (A), whose source terminals are connected to the operating voltage and earth, respectively, and whose drain terminals are connected to one of the two amplifier paths (1, 2), two parallel paths of amplifier paths and control transistors being produced, and the two paths being connected to one another between amplifier path and control transistor in each case by means of at least one resistor (R3, R4).

16. Amplifier according to Claim 15, **characterized in that** a capacitor (C12, C11) is in each case connected in parallel with the resistors (R3, R4).

## Revendications

1. Amplificateur différentiel, complémentaire, pour amplifier notamment des signaux de haute fréquence, comprenant une première branche (1) d'amplificateur MOSFET complémentaire qui a un transistor à canal p et un transistor à canal n monté en série avec celui-ci, et une deuxième branche d'amplificateur MOSFET complémentaire qui a également un transistor à canal p et un transistor à canal n monté en série avec celui-ci, dans lequel
- la deuxième branche (2) d'amplificateur fonctionne en sens contraire par rapport à la première branche (1) d'amplificateur
- les sorties des deux branches (1, 2) d'amplificateur forment une sortie différentielle et sont reliées l'une à l'autre respectivement par une résistance (R1, R2) de charge en un point (A) nodal, et
- le point de travail des deux branches (1, 2) d'amplificateur est réglé par la tension appliquée à ce point (A) nodal,
**caractérisé**
**en ce qu'**il est prévu des moyens (R3, R4 ; C11, C12) de réaction pour la première et pour la deuxième branche d'amplificateur.

2. Amplificateur suivant la revendication 1, **caractérisé en ce que** les branches (1, 2) d'amplificateur sont commandées autour de la moitié de la tension (Vdd/2) de fonctionnement.

3. Amplificateur suivant la revendication 1 ou 2, **caractérisé en ce que** la largeur de bande de l'amplificateur peut être modifiée en faisant varier les résistances (R1, R2) de charge.

4. Amplificateur suivant au moins l'une des revendications 1 à 3, **caractérisé en ce que** le point de travail des deux branches (1, 2) d'amplificateur est réglé en réglant la tension de grille d'au moins deux transistors (T1, T6) de commande FET qui commandent l'apport de courant aux deux branches (1, 2) d'amplificateur, la borne de grille des transistors (T1, T6) de commande FET étant couplée respectivement au point (A) nodal.

5. Amplificateur suivant la revendication 4, **caractérisé en ce que** les transistors de commande FET forment un transistor (T1) de commande à canal p et un transistor (T6) de commande à canal n, monté en série avec celui-ci, d'une paire de transistors MOSFET complémentaires qui commandent l'apport de courant à la première et à la deuxième branche (1, 2) d'amplificateur.

6. Amplificateur suivant la revendication 5, **caractérisé en ce qu'**il est appliqué à la borne de source du transistor (T1) de commande à canal p la tension de fonctionnement et à la borne de source du transistor (T6) de commande à canal n la masse, et la première et la deuxième branche (1, 2) d'amplificateur sont disposées entre les bornes de drain des deux transistors (T1, T6) de commande.

7. Amplificateur suivant la revendication 6, **caractérisé en ce que** la borne de drain du transistor (T1) de commande à canal p est reliée à la borne de source du transistor (T2) à canal p de la première branche (1) d'amplificateur et à la borne de source du transistor (T3) à canal p de la deuxième branche (2) d'amplificateur, et la borne de drain du transistor (T6) de commande à canal n est reliée à la borne de source du transistor (T4) à canal n de la première branche (1) d'amplificateur et à la borne de source du transistor (T5) à canal n de la deuxième branche (2) d'amplificateur.

8. Amplificateur suivant au moins l'une des revendications 4 à 7, **caractérisé en ce que** les transistors (T1, T6) de commande FET fonctionnent dans le domaine de triode.

9. Amplificateur suivant au moins l'une des revendications 1 à 8, **caractérisé en ce que** la première et la deuxième branche (1, 2) d'amplificateur sont formées respectivement par des transistors (T2, T4 ; T3, T5) à canal p et à canal n CMOS dont respectivement deux sont constitués de façon identique.

10. Amplificateur suivant au moins l'une des revendications précédentes, **caractérisé en ce que** le point (A) nodal est couplé à un condensateur (C2).

11. Amplificateur suivant au moins l'une des revendications précédentes, **caractérisé en ce que** le point (A) nodal est relié respectivement par un filtre (R5, C21 ; R6, C22) passe-bas aux bornes des grilles des transistors (T1, T6) de commande.

12. Amplificateur suivant au moins l'une des revendications précédentes, **caractérisé en ce qu'**il est associé aux transistors (T1, T6) de commande respectivement un circuit de miroir de courant ayant un transistor (T7, T8) MOSFET dont l'entrée est reliée au point (A) nodal et dont la sortie est reliée à la borne de source du transistor (T1, T6) de commande respectif.

13. Amplificateur suivant la revendication 12, **caractérisé en ce que** les transistors (T1, T6) de commande fonctionnent dans le domaine de pincement.

14. Amplificateur suivant au moins l'une des revendications précédentes, **caractérisé en ce que** les moyens de réaction ont des résistances (R3, R4) qui sont raccordées respectivement aux bornes de source de la première et de la deuxième branche (1, 2) d'amplificateur.

15. Amplificateur suivant la revendication 14, **caractérisé en ce que** les transistors de commande sont répartis respectivement en deux transistors (T1', T1" ; T6', T6") de mêmes dimensions dont les bornes de grille sont reliées au point (A) nodal, aux bornes de source desquels s'applique la tension de fonctionnement ou la masse et dont les bornes de drain sont reliées à l'une des deux branches (1, 2) d'amplificateur, deux branches parallèles de branches d'amplificateur et de transistors de commande étant créées et les deux branches entre la branche d'amplificateur et le transistor de commande étant reliées entre elles respectivement par au moins une résistance (R3, R4).

16. Amplificateur suivant la revendication 15, **caractérisé en ce qu'**il est monté respectivement un condensateur (C12, C11) en parallèle avec les résistances (R3, R4).
